# EUROPEAN PATENT APPLICATION

(11) **EP 1 643 556 A2**
(43) Date of publication of application: **05.04.2006**
(21) Application number: 06000806.7
(22) Date of filing: 16.01.2006
(51) Int. Cl.: H01L 27/146

(54) **Contact image capturing structure**

(71) Applicant: ELEC VISION INC., Science-Based Industrial Park Hsin-chu (TW)
(72) Inventor: Chen, Neng Chin, Science-Based Industrial Park Hsin-chu (TW)
(74) Representative: Casalonga, Axel

(57) **Abstract**

The present invention provides a contact image capturing structure comprising a substrate having a circuit layer, a detect chip located on the substrate and electrically connected to the circuit layer, a frame located on the substrate and surrounding the detect chip, a cavity is formed between the frame and the detect chip, and a transparent layer located in the frame to cover the detect chip and the circuit layer. The transparent layer above the detect chip is flat and the transparent layer above the cavity is slanted. Hence, the present invention can greatly reduce volume of the chip packaging structure, since the conventional optical devices are no more required. In addition, with the directly contact detection, the detected images can be directly displayed.

## Description

The invention relates to an image detecting structure, and more particularly, to a contact image capturing structure with small volume and can directly display images.

As the advance of the society, the image detecting technology is applied to more and more electronic products, such as the digital camera, biosensor and fingerprint identifier.

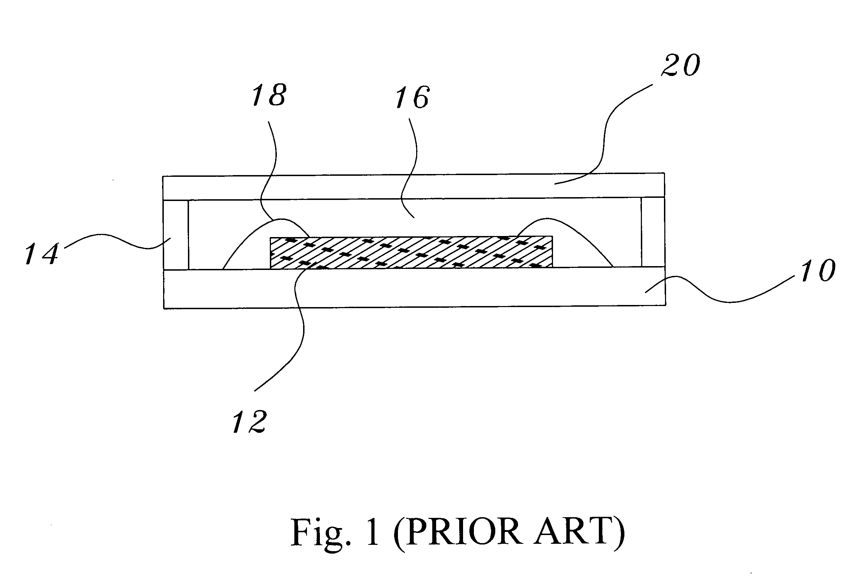

The packaging structure of the conventional detect chip is shown in Fig.1. The conventional structure includes a substrate 10, a detect chip 12 installed on the substrate 10, a flange 14 formed on the substrate 10 and around the detect chip 12, a fillister 16 formed by the flange 14 and the substrate 10, and a plurality of conducting wires 18 electrically connecting the detect chip 12 and the substrate 10. A transparent board 20 is adhered on the flange 14 to cover the fillister 16, and the substrate 10, the transparent board 20 and the flange 14 form a cavity to package the detect chip 12. However, this kind of packaging structure of the detect chip cannot be further narrowed, since size of the detect chips must cooperate with the formation distance of images. In addition, the packaging structures utilize the refraction or diffraction principles to form the images, so that the images cannot be displayed originally. After the refraction or diffraction processes, the images will be decayed and distorted, and the resolution of the images cannot be further improved.

Hence, the present invention discloses a contact image capturing structure to overcome the disadvantages of the conventional technology.

It is therefore a primary objective of the claimed invention to provide a contact image capturing structure that the detect chip can form images via contact detecting method without any optical device, and the detected images can be directly displayed.

It is therefore another objective of the claimed invention to provide a contact image capturing structure that the volume of the packaging structure can be greatly reduced, since the conventional optical devices are no more needed.

It is therefore a further objective of the claimed invention to provide a contact image capturing structure that the images can be directly displayed so that, in the application of the fingerprint identifying field, can be applied to the fingerprint identification of the living.

According to the claimed invention, a contact image capturing structure comprises a substrate having a circuit layer, a detect chip located on the substrate and electrically connected to the circuit layer, a frame located on the substrate and surrounding the detect chip, a cavity is formed between the frame and the detect chip, and a transparent layer located in the frame to cover the detect chip and the circuit layer. The transparent layer above the detect chip is flat and the transparent layer above the cavity is slanted.

These and other objectives of the present invention will no doubt become obvious to those of ordinary skill in the art after reading the following detailed description of the preferred embodiment that is illustrated in the various figures and drawings.
Fig.1 is a cross-sectional view of the prior art.
Fig.2 is a cross-sectional view of the concave arc shaped cavity according to the present invention.
Fig.3 is a flow chart of fabrication according to the present invention.
Fig.4 is a cross-sectional view of the convex arc shaped cavity according to the present invention.
Fig.5 is a cross-sectional view of the light guide board placed on the frame according to the present invention.
Fig.6 is a cross-sectional view of the opaque board placed on the frame according to the present invention.
Fig.7 is a cross-sectional view of the present invention in use.

| | | | |
|---|---|---|---|
| 10 | substrate | 12 | detect chip |
| 14. | flange | 16 | fillister |
| 18 | conducting wire | 20 | transparent board |
| 30 | substrate | 32 | circuit layer |
| 34 | detect chip | 36 | frame |
| 38 | cavity | 40 | transparent layer |
| 42 | auxiliary light source | 43 | filtering layer |
| 44 | plate | 46 | opening |
| 48 | auxiliary light source | 50 | finger |

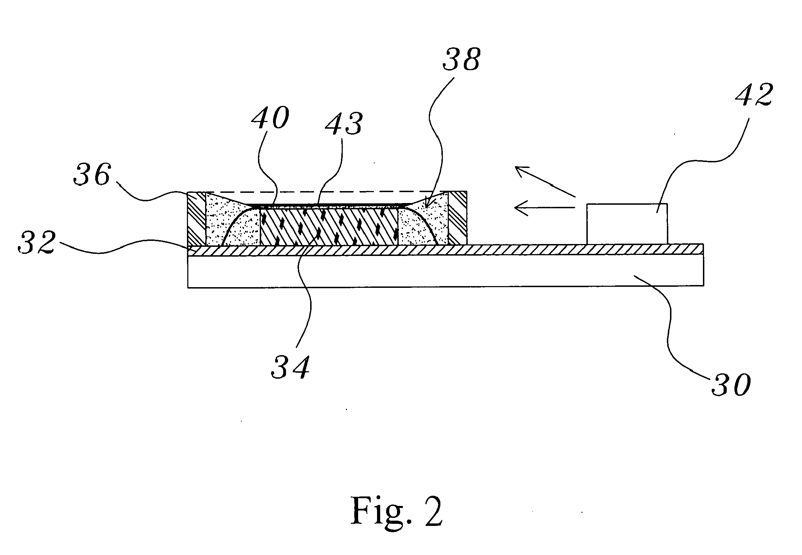

The claimed invention discloses a contact image capturing structure, and this structure can be applied to various fields, such as fingerprint identification, biosensor and derma medical monitoring. The claimed invention will be explained in detail with the embodiment of the fingerprint identifier. As shown in Fig.2, the claimed contact image capturing structure comprises a substrate 30 having a circuit layer 32, and a detect chip 34 located on the substrate 30 and electrically connected to the circuit layer 32. Wherein the detect chip 34 is electrically connected to the circuit layer 32 by wire bonding type or flip chip type, and the detect chip 34 is selected from one of charge-coupled device (CCD) and complementary metal oxide semiconductor (CMOS). Then, a transparent frame 36 is formed on the substrate 30, and transmittance of the frame 36 is 10% to 30%. The frame 36 surrounds the detect chip 34, and a cavity 38 is formed between the frame 36 and the detect chip 34. A transparent layer 40 is formed on the detect chip 34 by a coating method, and the transparent layer 40 is un-conductive epoxy resin. Wherein thickness of the transparent layer 40 above the detect chip 34 is 10um to 150um. The transparent layer 40 is formed in the cavity 38 with molding method, and the transparent layer 40 above the cavity 38 is slanted.

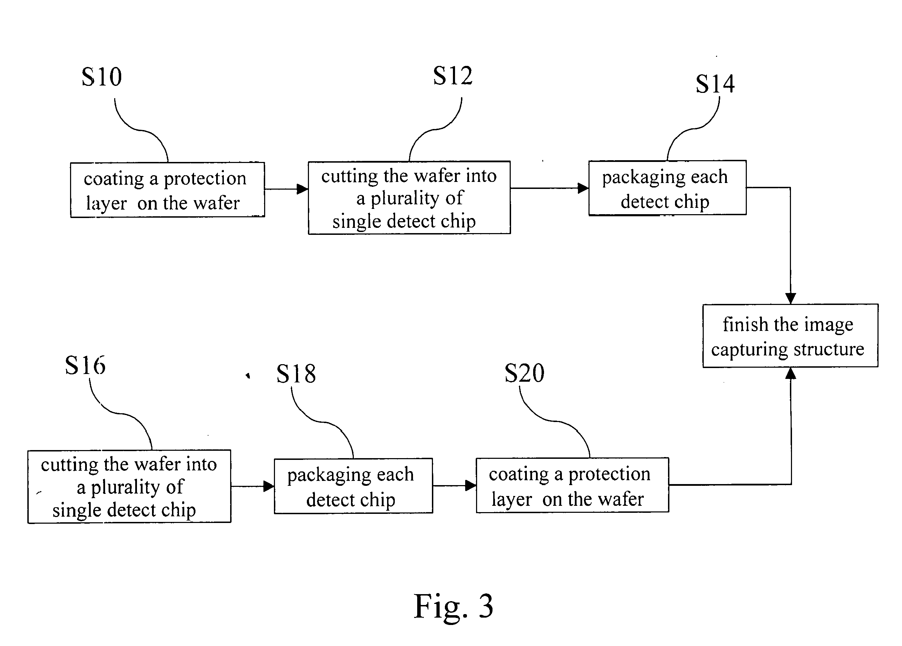

The fabrication of the transparent layer 40 on the detect chip 34 can be divided into two ways, as shown in Fig.3. The first fabrication method includes step S10, which coating a transparent layer 40 on the wafer having a plurality of detect chip 34; step S12, which cutting the wafer into a plurality of single detect chip 34; and step S 14, which packaging each detect chip 34 with the above-mentioned method to finish the image capturing structure. The second fabrication method includes step S16, which cutting a wafer into a plurality of single detect chip 34; step S 18, which individually packaging each detect chip 34 into modules having a plurality of frames 36 and performing the coating process; and step S20, which cutting modules having a plurality of frames 36 after packaging and coating. Then, the transparent layer 40 on the detect chip 34 is completely equipped.

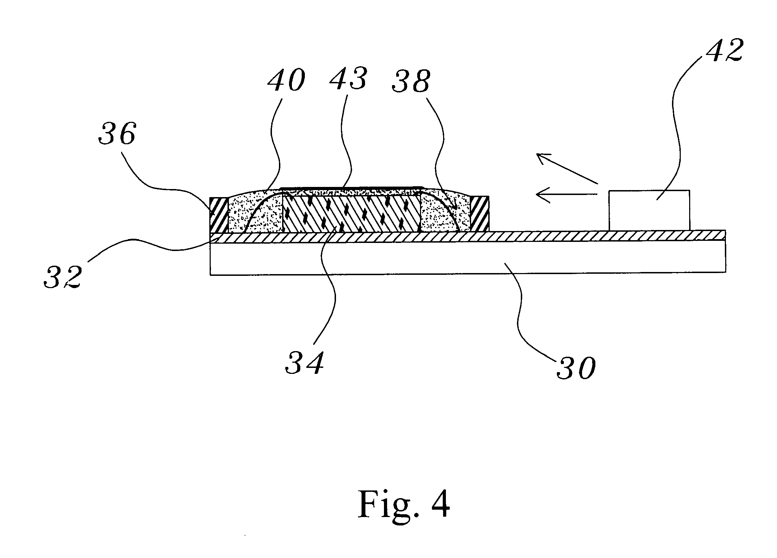

Please also refer to Fig.2 and Fig.4, the slanted transparent layer 40 above the cavity 38 is concave arc shaped or convex arc shaped, wherein height of the frame 36 is 0.05mm to 0.2mm higher than the detect chip 34 when the transparent layer 40 above the cavity 38 is concave arc shaped, and height of the frame 36 is 0.05mm to 0.2mm lower than the detect chip 34 when the transparent layer 40 above the cavity 38 is convex arc shaped. In addition, an auxiliary light source 42 is further designed outside the frame 36 and on the substrate 30, and the auxiliary light source 42 is one of the cold cathode fluorescent lamp or the bulb. In addition, a filtering layer 43 can be further formed on the transparent layer 40 to filter one of infrared light or ultraviolet light. Then, the contact image capturing structure is completely equipped.

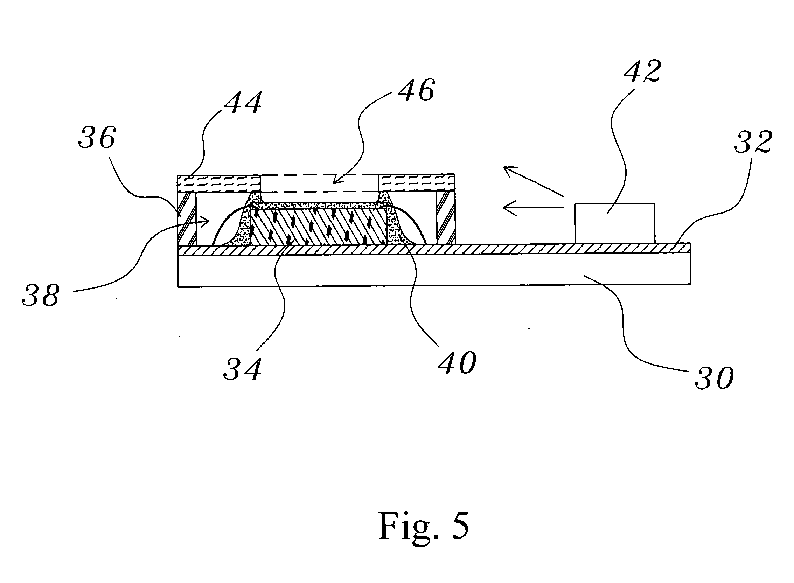

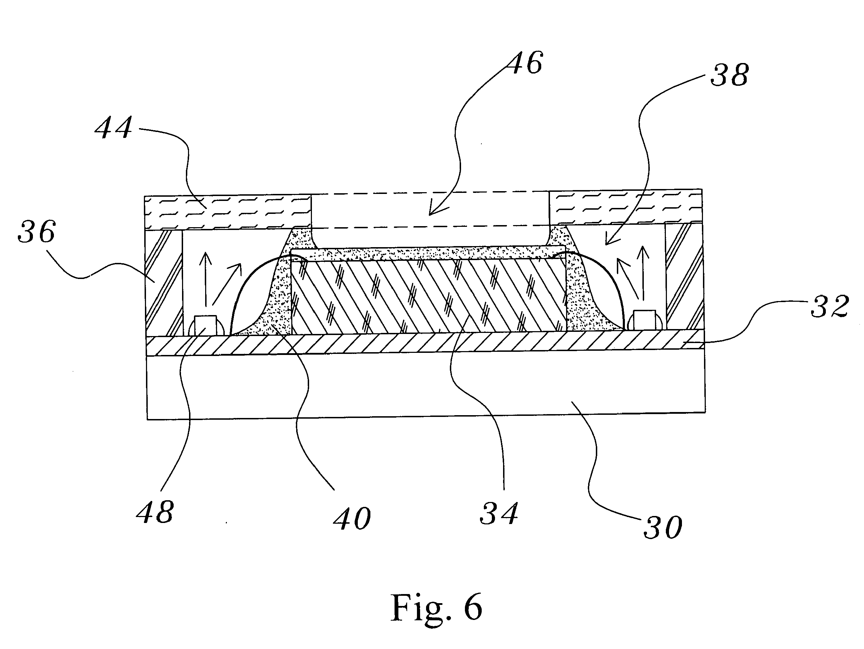

Except the above-mentioned embodiment, the claimed contact image capturing structure can be also achieved with another type. Please refer to Fig.5, the structure is similar to the above one but a plate 44 is designed on the frame 36. The plate 44 is a light guide board and whereon has an opening 46 corresponding to top of the detect chip34. A gap is formed between the plate 44 and the detect chip 34, and width of the gap is 0.1mm to 0.6mm. Then, the un-solidified transparent layer 40 (liquid state) is placed on the detect chip 34, and the liquid transparent layer 40 will fill the gap since the surface tension of the liquid transparent layer 40 can make it cohering on the plate 44 of the opening 46 while spreading. The transparent layer 40 is heated to solidify, and the cavity 38 below the plate 44 is sealed to isolate air. This contact image capturing structure utilizes the plate 44 to guide the auxiliary light source 42 to complement the light. Besides, the plate 44 can be also an opaque board, as shown in Fig.6. An auxiliary light source 48 should be designed on the substrate 30 and in the cavity 38 when the plate 44 is opaque. Since the space of the cavity 38 is limited, the auxiliary light source 48 may be a light emitting diode (LED). Light of the auxiliary light source 48 can pass through the gap between the plate 44 and the detect chip 34 and emit out.

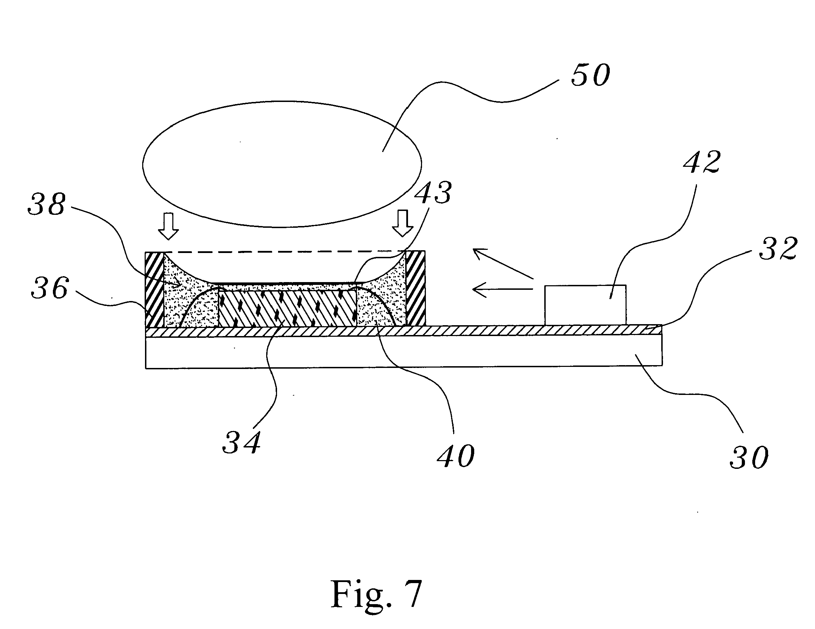

While practicing the claimed invention, as shown in Fig.7, a finger 50 is put on the transparent layer 40 above the detect chip 34, and the auxiliary light source 42 outside the frame 36 will emit light. The light passes through the frame 36 to illuminate the fingerprint of the finger 50 and the images detected by the detect chip 34 are enhanced. The hemachrome in human blood can absorb light, so when the detect chip 34 is applied to detect the fingerprint, the detected images will have a continuous light and shade circulation because of the human pulses. So the claimed contact image capturing structure can be also applied to the fingerprint identification of the living. Furthermore, with the directly contact detection, the detect chip 34 can form images without any optical device, and the detected images can be directly displayed. The volume of the packaging structure of the detect chip 34 can be also greatly reduced, since the conventional optical devices are no longer needed.

Those skilled in the art will readily observe that numerous modifications and alterations of the device may be made while retaining the teachings of the invention. Accordingly, the above disclosure should be construed as limited only by the metes and bounds of the appended claims.

## Claims

1. A contact image capturing structure, comprising:
a substrate having a circuit layer;
a detect chip located on the substrate and electrically connected to the circuit layer;
a frame located on the substrate and surrounding the detect chip, a cavity is formed between the frame and the detect chip; and
a transparent layer located in the frame to cover the detect chip and the circuit layer, the transparent layer above the detect chip is flat and the transparent layer above the cavity is slanted.

2. The contact image capturing structure of claim 1, wherein a first auxiliary light source is further designed outside the frame and on the substrate.

3. The contact image capturing structure of claim 2, wherein the first auxiliary light source is cold cathode fluorescent lamp or bulb.

4. The contact image capturing structure of claim 1, wherein thickness of the flat transparent layer above the detect chip is 10 um to 150 um.

5. The contact image capturing structure of claim 1, wherein the slanted transparent layer above the cavity is concave arc shaped or convex arc shaped.

6. The contact image capturing structure of claim 5, wherein height of the frame is 0.05 mm to 0.2 mm higher than the detect chip when the transparent layer above the cavity is concave arc shaped.

7. The contact image capturing structure of claim 5, wherein height of the frame is 0.05 mm to 0.2 mm lower than the detect chip when the transparent layer above the cavity is convex arc shaped.

8. The contact image capturing structure of claim 1, wherein the detect chip is electrically connected to the circuit layer of the substrate by wire bonding type or flip chip type.

9. The contact image capturing structure of claim 1, wherein the transparent layer is un-conductive.

10. The contact image capturing structure of claim 1, wherein the transparent layer is optical colloid, such as epoxy resin.

11. The contact image capturing structure of claim 1, wherein the detect chip is one of charge-coupled device (CCD) and complementary metal oxide semiconductor (CMOS).

12. The contact image capturing structure of claim 1, wherein transmittance of the frame is 10% to 30%.

13. The contact image capturing structure of claim 1, wherein a plate is placed on the substrate and the frame, the plate has an opening and the opening corresponds to top of the detect chip, and a gap is formed between the plate and the detect chip.

14. The contact image capturing structure of claim 13, wherein the plate is one of light guide board and opaque board.

15. The contact image capturing structure of claim 14, wherein a second auxiliary light source is designed on the substrate and in the cavity when the plate is opaque board.

16. The contact image capturing structure of claim 15, wherein the second auxiliary light source is light emitting diode (LED).

17. The contact image capturing structure of claim 13, wherein the transparent layer covers the detect chip and fills the gap to seal the cavity.

18. The contact image capturing structure of claim 1, wherein the transparent layer is formed in the placing space with molding method, and wherein the transparent layer is formed in the on the detect chip by a coating method.

19. The contact image capturing structure of claim 18, wherein the transparent layer is coated on the wafer having a plurality of detect chip, which cutting the wafer into a plurality of single detect chip.

20. The contact image capturing structure of claim 1, wherein a filtering layer can be further formed on the transparent layer to filter one of infrared light or ultraviolet light.
